Europäisches Patentamt

European Patent Office

Office européen des brevets

(19)

(11) **EP 1 239 596 B1**

(12) **EUROPEAN PATENT SPECIFICATION**

(45) Date of publication and mention
of the grant of the patent:
**30.11.2005 Bulletin 2005/48**

(51) Int Cl.⁷: **H03M 13/27**

(21) Application number: **02075867.8**

(22) Date of filing: **26.01.1996**

(54) **Method of error protected transmission, method of error protected reception of data and transmission system for transmission of data**

Fehlerbeschütztes Datenübertragungs-und Empfangsverfahren und Datenübertragungssystem

Procédé de transmission et réception, protégées contre les erreurs de données et système de transmission de données

(84) Designated Contracting States:
**DE DK GB IT SE**

(30) Priority: **01.02.1995 EP 95200242**

(43) Date of publication of application:
**11.09.2002 Bulletin 2002/37**

(62) Document number(s) of the earlier application(s) in accordance with Art. 76 EPC:
**96900404.3 / 0 760 182**

(73) Proprietor: **Koninklijke Philips Electronics N.V.**
**5621 BA Eindhoven (NL)**

(72) Inventor: **Baggen, Constant Paul Marie Jozef**
**5656 AA Eindhoven (NL)**

(74) Representative: **Groenendaal, Antonius W. M.**
**Philips**
**Intellectual Property & Standards**
**P.O. Box 220**
**5600 AE Eindhoven (NL)**

(56) References cited:
**EP-A- 0 370 444**

## Description

Method of transmission and reception of data. The invention relates to a method of transmission and reception of data, a transmission system for the transmission and reception of data, a transmitting section and receiving section for such a system.

A method and system of this kind is known from the book "Error correction coding for digital communications" by G.C. Clark and J.B. Cain, Plenum Press New York, 1981, sections 8.5 and 8.3.2.

The cited book describes a system which is intended to counteract jamming. This is achieved by a spread spectrum technique, which involves greatly expanding the transmit spectrum relative to the data rate. The idea is that this forces the jammer to deploy his power over a much wider bandwidth than would be necessary for an unspread spectrum.

The anti-jamming system modulates the information successively at different frequencies. As a function of time, the frequency "hops" from one frequency channel to another. To protect against jammed channels the information is encoded in an error correction code prior to modulation. In addition, the encoded information is interleaved: the time sequential order in which the data-items are modulated is permuted with respect to the order in which they succeed each other in the error protection code. In the prior art technique, interleaving serves to make the anti-jamming system more robust against pulses that jam all frequency channels for part of the time.

The described system makes very inefficient use of the frequencies available. This forces the jammer to deploy his power over a much wider bandwidth and is therefore essential for anti-jamming as described in the book by G.C. Clark and J.B. Cain.

It is inter alia an object of the invention to apply pseudo random interleaving to applications which make more efficient use of the frequencies available.

It is a further object of the invention to provide for multichannel broadcasting which is robust against degradation due to multipath transmission and which makes efficient use of the frequencies available.

The invention provides for a method of transmission and reception of data, the method comprising

- a transmitting step comprising transmitting data-items that are pseudo-random interleaved, the data-items being transmitted modulated in a number of simultaneously active frequency channels;
- a receiving step comprising receiving and de-interleaving the transmitted data-items, characterized in that the de-interleaving comprises writing the received data-items into locations in a memory in an order of writing, and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function, the data-items being interleaved so as to provide an inverse of the de-interleaving. As a result of the simultaneous transmission of information in a number of frequency channels, the frequencies available are efficiently used. The invention addresses the problem of transmission channels that may suffer from multipath transmission rather than from jamming. In the case of wireless broadcasting, for example indirect transmission may occur in addition to direct transmission of electromagnetic radiation, for example due to reflection of the radiation by a building. It has been found that this often leads to variations in the receivability of the various frequency channels. Moreover, it has been found that this variation is often periodic, i.e. it recurs as a function of the frequency after a number of channels. The recurrent period is dependent on the receiving conditions and, generally speaking, it cannot be predicted.

The use of pseudo-random interleaving prevents multipath transmission from causing burst errors that are so long that they cannot be corrected.

Thus, interleaving is performed by writing data items into a memory and by subsequently reading the data items therefrom in a different order. New data is then written into memory locations vacated by reading before all other locations have been read, which makes it possible to save memory space. For monotonously ascending address series this is known per se from US 5,151,976. The invention, however, applies this operation to the writing according to a pseudo- random sequence. Despite the fact that such a pseudo-random sequence is far more complex than a monotonous series, it has been found that notably the use of direct writing after reading with random sequences can be used for interleaving.

Moreover, document EP370444 discloses an interleaving method in which symbols to be interleaved are written into an interleaving memory at an address at which interleaved symbols have just been read-out from the interleaving memory following a pseudo-random read/write address sequence.

In the method of the invention the memory addresses are selected alternately as a monotonously ascending or descending order and as the pseudo random function of that order. By using only two different series of addresses in an alternating fashion, interleaving is simplified.

In an embodiment of the invention, the addresses are calculated according to a linear congruen-

tial sequence satisfying:

$$X_{n+1} = (aX_n + c) \bmod M$$

n being the position of a particular data-item in the second order, $X_n$ being the address from which that particular data-item is read, M being the number of selectable memory locations, a and c being a factor and a summand for a linear congruential sequence respectively, the combination of the factor and the summand used being changed for each version of the basic cycle. The factor a and summand c for linear congruential sequences are such that c is a relative prime with respect to M, a-1 is a multiple of all primes factors of M, and a-1 is a multiple of 4 if m is a multiple of 4. This provides for a simple way of generating the addresses. In particular it has been found that, when all "a" used for different versions are such that the square of (a-1) is divisible by M, it is ensured that all orders of addresses which are successively required to read data-item that have been written in the order of locations in which the preceding data-items have been read, can always be generated in correspondence with this formula.

The invention also related to a method of receiving data, and to a system for applying the method and its components, to which similar measures can be applied mutatis mutandis to obtain similar advantages.

These and other aspects of the invention will be apparent from and elucidated with reference to the embodiments described hereinafter.

In the drawings:

    Fig. 1 shows a transmission system;
    Fig. 2 shows an embodiment of an interleaver;
    Fig. 3 shows a further embodiment of an interleaver; and
    Fig. 4 shows an embodiment of an address generator.
    Fig. 5 shows an embodiment of the transmitting section according to the invention.

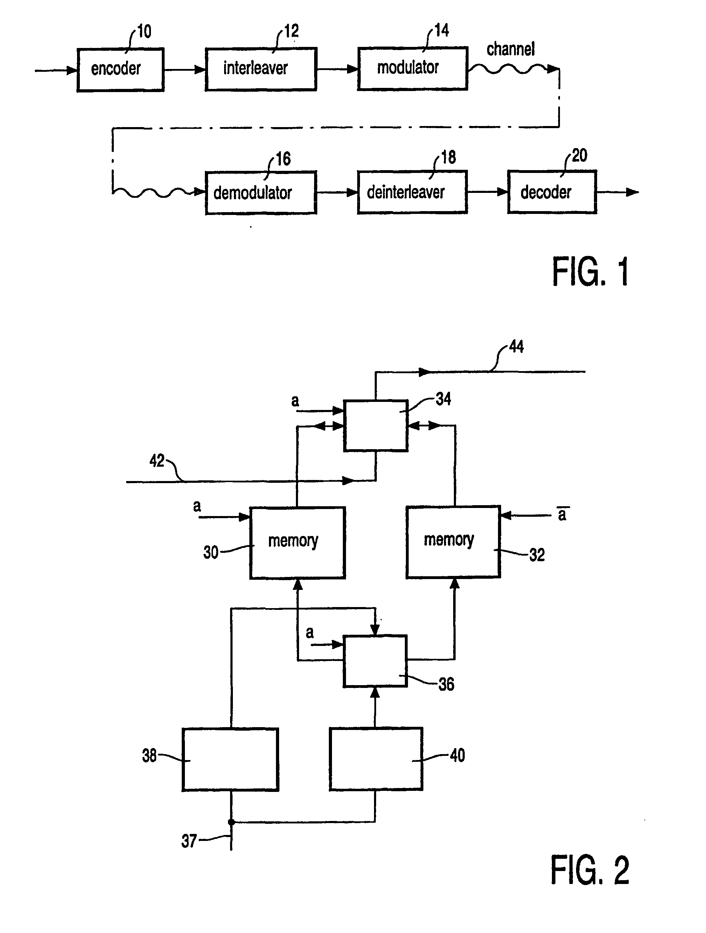

Fig. 1 shows a transmission system. It comprises a cascade connection of successively an encoder 10, an interleaver 12, a modulator 14, a transmission channel, a demodulator 16, a de-interleaver 18 and a decoder 20.

During use data is presented to an input of the encoder 10. The encoder 10 encodes this data in an error correction code. Any known error correction code, for example a convolution code, can be used for this purpose. The encoded data is composed of, for example blocks, each of which contains a logic succession of bits.

The decoder 20 corresponds to the encoder 10 and corrects bit errors incurred during transmission from the encoder 10 to the decoder 20. The error correction code is such that bit errors which occur distributed throughout the logic succession can be readily corrected. Burst errors, where a number of successive bits in the logic succession are incorrect, can be less readily corrected when they are too long.

The modulator 14 produces a signal with a number of frequency channels which are simultaneously transmitted. The bits of each block are distributed among a number of groups. Each group corresponds to a frequency channel and the information of the bits in a group is transmitted in the corresponding frequency channel. This can be realised, for example by interpreting the bits of each group as a number, by arranging these numbers in a series and making an FFT (fast Fourier transform) of the series. The result of the FFT is subsequently transmitted via the transmission channel, for example a wireless terrestrial broadcast channel. FFT and transmission are repeated for successive blocks. This corresponds to the known OFDM (orthogonal frequency division multiplexing) technique.

The demodulator 16 corresponds to the modulator 14. The demodulator receives the various frequency channels simultaneously and reconstructs the groups of bits transmitted in a respective frequency channel. According to the OFDM technique, this is performed, for example by making an inverse FFT of the signal received and by reconstructing the numbers and hence the groups therefrom.

The interleaver 12 serves to ensure that bits which are directly adjacent in the logic succession are substantially always modulated in different frequency channels. The spacing of these channels (in terms of channels with intermediate frequencies) is preferably larger than zero, so that adjacent bits will enter non-adjacent channels. This serves to ensure that a disturbance of a single channel, or of a number of neighbouring channels, does not lead to burst errors in the logic succession.

The de-interleaver 18 corresponds to the interleaver 12 and performs the reverse operation, so that the logic succession is reconstructed in terms of order (i.e. except for bit errors) before being presented to the decoder 20.

The interleaver 12 places every adjacent pair of bits, which succeed one another in the logic succession, at a respective distance, amounting to a number of channels, from one another. The respective distances have different values and it is ensured that the various distances occur approximately equally frequently. As a result, the system is robust to disturbances of the transmission channel which lead to poor reception in a periodic system of frequency channels (in this context a periodic system is to be understood to mean a system in which the poor reception recurs as a function of the frequency each time after the same number of channels).

All other pairs of bits which are so near to one another that a simultaneous error in the bits of such a pair could give rise to burst problems are also placed at a respective distance of a number of channels from one another. These respective distances preferably also have different values and it is ensured that these different distances occur approximately equally frequently.

Fig. 2 shows an embodiment of an interleaver; this device is also suitable as a de-interleaver. The interleaver of Fig. 2 comprises a data input 42 which is coupled, via a multiplexer 34, to respective data inputs/outputs of a first and a second memory 30, 32. The data inputs/outputs of the memories 30, 32 are also coupled, via the multiplexer 34, to an output 44 of the interleaver.

The interleaver also comprises a clock input 37, coupled to clock inputs of a first and a second address generator 38, 40. The output of each of the address generators is coupled to a further multiplexer 36. The outputs of the further multiplexer 36 are coupled to a respective address input of the first and the second memory 30, 32.

During operation the interleaver is switched to and fro between two modes. In a first mode the multiplexer 34 couples the input 42 to the data input of the first memory 30 and the output 44 to the data output of the second memory 32. Furthermore, the further multiplexer 36 couples the output of the first address generator to the address input of the first memory 30 and the output of the second address generator 40 to the address input of the second memory 32. In the second mode the roles of the first and the second memory 30, 32 are reversed in comparison with the first mode.

The first address generator 38 generates a clocked first series of addresses. The various data items presented to the input 42 during successive clock cycles are written at these addresses. Data is read from the second memory 32 in a similar manner, addressed by a second series of addresses from the second address generator, and applied to the output 44. The first and the second series of addresses deviate from one another, resulting in interleaving.

The first series of addresses is, for example a monotonously ascending series (1, 2, 3 ...) and the second series of addresses is a pseudo-random series, for example a series in which a respective difference exists between each pair of directly successively generated addresses; these respective differences have various values and it is ensured that the various values occur approximately equally frequently. The differences correspond to the distances between the frequency channels in which successive bits of the logic succession are arranged.

The corresponding de-interleaver has the same structure as shown in Fig. 2, be it that the first address generator of the de-interleaver generates the same address series as the second address generator of the interleaver and vice versa.

The pseudo-random series can be generated by assembling the address generator 40 from a counter and a ROM, successive pseudo-random addresses being stored in successive locations in the ROM. Alternatively, use can be made of a known linear congruent series, the addresses $X_n$ for the memory 32 being obtained by way of the recursion relation:

$$X_{n+1} = (a X_n + c) \bmod M$$

These addresses can be obtained by multiplication and addition, without utilizing a ROM. A further alternative consists in the use of an LFSR (Linear Feedback Shift Register).

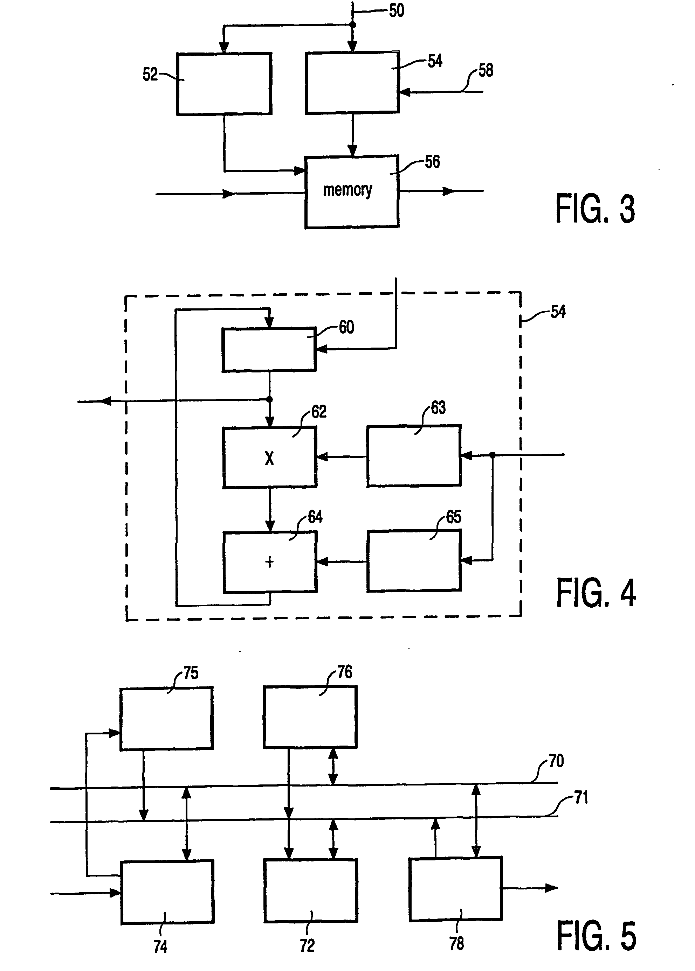

Fig. 3 shows a further embodiment of an interleaver. This embodiment comprises only one memory 56. The input and the output of the interleaver are coupled to a data input and a data output, respectively, of this memory 56. The interleaver also comprises a clock input 50 which is coupled to an address generator 54. An output of the address generator 54 is coupled to an address input of the memory 56. The clock input 50 is also coupled, via a read/write control unit 52, to a read/write control input of the memory.

The address generator 54 generates a series of addresses during operation. For each address a first data item is read from the memory 56 so as to be applied to the output; subsequently, the read/write control circuit switches the memory to the write mode and a data item originating from the input is written into the memory at the same address.

The address generator 54 each time generates such a series of addresses. Each series contains substantially the same addresses. The order in which the addresses succeed one another in directly successive series, however, differs each time. For example, alternately a pseudo-random series $(X_1, X_2, X_3 ... x_n)$ and a normal monotonously ascending series (1, 2, 3 ... N) can be taken. This results in interleaving with a substantially uniform distribution of the differences between successive addresses.

By using only two different series of addresses in an alternating fashion, de-interleaving is simplified (same two series, so that each time the data items are written in the de-interleaver in memory locations which correspond to the locations wherefrom they have been read in the interleaver). However, this approach has the drawback that the method of interleaving is often repeated, so that the transmission system becomes susceptible to systematic disturbances.

Therefore, as an attractive alternative it is possible to use more than two different series and to repeat the pattern of series of addresses used only after more than two complete series. To this end, for broadcast applications a linear congruential sequence is preferably used at the receiving side in the de-interleaver, because such a sequence can be simply implemented. At the transmission side, for example an interleaver comprising a ROM is then used, the ROM containing the inverse permutation of what the de-interleaver contains at the receiving side. Given the permutation realised by the interleaver, this inverse permutation can be calculated, for example numerically. If a recurrent pattern of mutually different series of addresses is used in the de-interleaver, including a monotonously ascending series (1, 2, 3), this inverse permutation requires only a limited amount of space in the memory ROM.

When different address series are used, a synchronization signal is desirable between the receiving side and the transmission side, so that the de-interleaver can start the pattern of series of addresses in the correct phase (so as to serve as the inverse of the interleaver). For this purpose use is preferably made of a transmitted synchronization signal which also serves to mark header information for the further processing of the encoded symbol.

Fig. 4 shows an embodiment of an address generator 54 for use in an interleaver as shown in Fig. 2 or 3. The address generator 54 comprises a register 60, an output of which is coupled to the output of the address generator and to a first multiplicand multiplier 62. The output of the multiplier 62 is coupled to a first summand input of an adder 64. The output of the adder 64 is coupled to an input of the register 60. The address generator comprises a factor memory 63 and a summand memory 65 which are coupled, by way of an output, to a second multiplicand input of the multiplier 62 and to a second summand input of the adder 64, respectively.

During operation the register 60 contains the address $X_n$ for the memory. Using the multiplier 62 and the adder 64, the next address is calculated in conformity with the formula:

$$X_{n+1} = (a X_n + c) \bmod M$$

where M is the length of the address series. The factor "a" and the summand "c" are derived from the factor memory 63 and the summand memory 65, respectively. Between successive series the memories 63, 65 receive signals, whereby another factor and/or summand is applied to the multiplier and the adder, so that subsequently a different series is generated. In one of the series, for example a=1 and c=1, resulting in a monotonously ascending series. In the other series a is then unequal to 1 and is chosen, in a manner which is known per se, so as to generate a pseudo-random sequence (c relative prime with respect to M, a-1 is a multiple of p for all primes p sharing M (e.g. if M=45=3*3*5 then a-1 must be a multiple of both 3 and 5) and a-1 is a multiple of 4 if M is a multiple of 4).

By storing a number of different usable values of a and c, a corresponding number of different series of addresses can be generated.

Preferably, the "a" values are selected only such that (a-1) squared is divisible by "M", i.e. such that (a-1) contains each prime factor of m at least half as many times as "M" itself (for example when M=675=3*3*5*5, (a-1) could be 45=3*3*5, in general large M values with several prime factors are required:

of the M values of 1 to 20 only M=8, 9, 12, 16, 18 qualify). It can be proven that, when only "a" values having the property that the square of (a-1) is divisible by M are used for generating the addresses, any pseudo random permutation of the bits described by the formula $X_{n+1}=$ (a $X_n$ + c) mod M can be realized with an "a" value that also satisfies this condition. Also it has been found that both the addresses for interleaving and deinterleaving can then be realized with such pseudo random permutations in that case. Hence no address ROM is needed. It has been found that this is true only when the square of (a-1) is divisible by M. In this case the addresses need not be calculated by actually calulating the formula $X_{n+1}=$ (a $X_n$ + c) mod M. In stead, one may use $X_{n+1}=$ $X_n + v_n$ mod m; $v_{n+1}= v_n + d$ mod m, with d=c(a-1), and $v_0$ initialized to (a-1)$X_0$+c. (For example, when M=100 (=2*2*5*5), "a" may be chosen as 21 (a-1=4*5) and c=1).

When the modulus M with which the multiplier and adder operate is made adjustable, the interleaver/de-interleaver can be simply switched between different block lengths.

Evidently, the invention is not restricted to the embodiments given. For example, instead of operating with bits it is also possible to operate with larger symbols, for as long as the error correction code is capable of correcting random and isolated errors in these symbols better than random errors in the form of a burst.

Furthermore, the logic succession of bits produced by the encoder is not necessarily a temporal succession. Bits are "logically successive" if simultaneous errors in these bits can be corrected less readily than simultaneous errors in "non-logically successive" bits.

The inner frequency interleaving is a pseudo-random bit interleaving. The interleaving is on a block basis, *i.e.*, the bits in each OFDM symbol are permuted in a fixed way such that bursts are randomized. However, bits of a given OFDM symbol are not mixed with bits originating from any other OFDM symbol.

In a practical example, an OFDM symbol consists of N useful subcarriers, where N equals 6361 or 5937, that each contain 2, 4 or 6 bits of information. The task of the interleaver is to decorrelate the bits at the input of a Viterbi detector.

The (de)interleaver consists of a memory (RAM) having the size of 8 times 8192 bit and an addressing unit. The addressing unit generates a 16 bit address that can be distinguished in 3 lsb bits and 13 msb bits. The 13 msb bits determine a particular subchannel, while the 3 lsb bits determine which bit from a given subchannel. Each time as the RAM is addressed, the contents are read and put forward to the downstream decoder and the next bit at the input is written in the current location. At each cycle, all relevant locations must be addressed. The three lsb bits periodically go through relevant states (dependent on the number of bits per symbol), while the 13 msb bits are generated by an algorithm producing all relevant addresses in a special sequence.

Since 6361 is prime and 5937 is divisible by three, the lsb addresses can be generated in pairs, an algorithm is defined that works for 2 bits of information per subcarrier and this algorithm is used 1, 2 or 3 times dependent on the number of bits per symbol, each time with a different fixed offset on the lsb. In this way it is assured that all bits will be addressed under all circumstances before the addressing unit will be in the same state.

One way of producing a periodic interleaver would be to generate the consecutive addresses $x_{t,n}$, 0, $n < N$ of the 13 msb bits in the OFDM symbol at time t according to:

$$x_{t,n+1} = x_{t,n} + c_t \bmod N \qquad (1)$$

with $x_{t,0} = 0$ t and $GCD(c_t,N) = 1$. The increment $c_t$ depends on the time t. For a periodic interleaver, we can choose $c_t = c_{t-1} * c_0 \bmod N$, where $c_0$ is a judiciously chosen initial increment that corresponds to the actually realized interleave depth.

In summary, the invention relates to a transmission system, which comprises an encoder, an interleaver, a modulator, a transmission channel, a demodulator a deinterleaver and a decoder. The encoder is used for encoding a data block in an error correction code containing a logic succession of data items. The decoder is used for correcting errors in the transmission between the encoder and the decoder. The error correction code is more robust to errors which occur simultaneously and in an isolated fashion in the logic succession than to errors which occur simultaneously and in the form of a burst therein. The modulator is used for generating a signal which comprises a number of frequency channels to be transmitted simultaneously, each of the frequency channels corresponding to a group which comprises at least one of the data items and is modulated in the respective channel. The transmission channel is located between the modulator and the demodulator. The demodulator reconstructs the groups and applies the groups to the decoder. The interleaver distributes the data items between the groups and introduces a pseudo-random relationship between the logic succession and the distribution between the successive frequency channels. The de-interleaver reconstructs the logic succession from the groups reconstructed by the demodulator, before presentation to the decoder.

This transmission system can be improved when the interleaver and/or the de-interleaver realise the distribution by way of a non-monotonous linear congruential sequence.

The transmission system can be further improved when the interleaver and/or the de-interleaver are provided with a memory for the data items and with write and read means, the write means writing each time a data item in a location of the memory which has just been read before the read means read a data item from a next location of the memory, and in which an order of locations in which the logic succession is written differs for successive logic successions.

A further improvement concerns a transmission system in which the orders are periodically recurrent with a period of at least two blocks in which one monotonously ascending or descending order occurs. Also the write and/or read means may comprise an address generator which is arranged to form a linear congruential sequence with a factor and a summand, and also arranged to replace the factor and/or the summand from one block to another.

Thus information can be transmitted by the following steps:

- encoding the data in an error correction code
- interleaving the data according to a pseudo-random sequence
- modulating the data in a series of frequency channels, data items which cannot be corrected together being arranged in separate frequency channels by interleaving,
- demodulating the data
- de-interleaving the data
- decoding the data.

Figure 5 shows an embodiment of the transmitting section according to the invention. The transmitting section contains a data bus 70 and a address bus 71 connecting a memory 72, a processor 76 and a transmitter 78. An encoder 74 is coupled to the data bus 70. The encoder 74 is coupled to the address bus 71 via an address generation unit 75.

In operation, the encoder 74 receives the data block and encodes it as a succession of bits. Each successive bit is fed to the data bus 70, and the presence of the bit is signalled to the address generator 75. The address generator 75 generates a respective address for each successive bit according to the pseudo random sequence. The address indicates both a word location in the memory 72 and a bit location within the word location. The word location corresponds to the group to which the bit is assigned, and the bit location corresponds to the location of the bit within the group. The address generator 75 ensures that bits which are logically adjacent are substantially always stored in different word locations. The spacing of these word locations is preferably larger than zero, so that logically adjacent bits will enter non-adjacent word locations.

The address is applied to the data bus and the bit is stored in the memory 72 at a location that corresponds to the address generated for it by the address generator 75. When the entire data block has thus been encoded in the error protecting code, and stored in the memory 72, the processor 76 is started. The processor 76 computes the FFT of the words stored in memory 72.

For this purpose, it reads the words each time as they are needed for the FFT algorithm. For this purpose a known FFT algorithm can be used, which addresses the word locations of the memory 72 in a normal way, i.e. without requiring knowledge of the interleaving process. Because the bits which are logically adjacent are substantially always stored in different word locations, these adjacent bits are modulated in different frequency channels in the result of the FFT. This result is subsequently read by the transmitter 78 and transmitted via the transmission channel (not shown).

A structure similar to that of figure 5 can be used for the receiving section, with a receiver replacing the transmitter 78 and a decoder replacing encoder 74. In this case the receiver writes words into memory 72 and the processor 76 performs an FFT on this words. Address generator 75 effects the pseudo random interleaving, issuing successive word/bit address pairs to read out the results of the FFT bit by bit for error correction by the decoder.

**Claims**

1. A method of transmission and reception of data, the method comprising

   - a transmitting step comprising transmitting data-items that are pseudo-random interleaved, the data-items being transmitted modulated in a number of simultaneously active frequency channels;
   - a receiving step comprising receiving and de-interleaving the transmitted data-items, **characterized in that** the de-interleaving comprises writing the received data-items into locations in a memory in an order of writing, and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function, the data-items being interleaved so as to provide an inverse of the de-interleaving.

2. A method according to Claim 1, wherein

   - the transmission step comprises:

     * encoding the data in each version of the basic cycle into a respective logic succession of data-items in an error correction code which is more robust against errors that are separate from each other than against errors that occur in a burst in the respective logic succession;
     * generating a signal comprising the frequency channels, the data-items for a version of the basic cycle being modulated in respective ones of the frequency channels that are simultaneously active;
     * selecting for each particular data-item a particular frequency channel dependent on a particular position of the data-item in its logic succession;
     * modulating each frequency channel of the signal in dependence on at least a respective one of the data items, the particular data item being modulated at the particular frequency channel;
     * transmitting the signal;

   - a receiving step comprising:

     * receiving the signal;
     * demodulating the data-items from frequency channels of the signal;
     * inverse selecting the logic position of the particular data-item in its respective logic succession, dependent on the particular frequency channel from which the particular data-item was demodulated;
     * decoding the data-items received from the reading means according to the error correcting code applied to the logic sequence obtained by said inverse selecting;

   - **characterized in that** the inverse selecting comprises:

     * upon reception from the demodulation, writing the data items from each particular version of the basic cycle into a memory in an order of writing addresses for the particular version;
     * reading the data items for that particular version from the memory in an order of reading addresses for the particular version, permuted according to a pseudo random function with respect to the order of writing addresses for the particular version, the writing of the data-items of the particular version being performed at addresses as these addresses come available during reading of the data items of a directly preceding version of the basic cycle;
     * generating the orders of writing and reading addresses, the order of reading addresses in the particular version of the basic cycle being permuted with respect to the order of reading addresses used in a directly preceding version of the basic cycle according to the pseudo random function, the pseudo random function being particular to the version of the basic cycle; the order of reading and writing addresses being repeated periodically, each order of reading addresses recurring each time after a period of exactly two versions of the basic cycle, the order of reading addresses being alternately a monotonously ascending or descending order of addresses and an order in which the addresses for reading are permuted according to the pseudo random function;

- wherein said selecting in the transmission step comprises selecting the particular frequency channel for positions in each respective logic succession so as to provide an inverse of the assignment of data-items from frequency channels to positions in the respective logic succession performed by the inverse selecting of the receiving step.

3. A method of transmission according to Claim 2, in which the addresses of the memory locations are calculated according to a linear congruential sequence satisfying:

$$Xn+1 = (a\, Xn + c) \bmod M$$

n being the position of a particular data-item in the order of reading addresses, Xn being the address from which that particular data item is read, M being the number of selectable memory locations a and c being a factor and a summand for a linear congruential sequence respectively, the combination of the factor and the summand being changed for each version of the basic cycle.

4. A receiving method for reception of data with data items being transmitted modulated in a number of simultaneously active frequency channels, the receiving method comprising receiving and de-interleaving the transmitted data, wherein de-interleaving comprises writing the received data-items into locations in a memory in an order of writing and reading the data-items in a de-interleaved order of reading, de-interleaving being performed in successive versions of a basic cycle, the data-items for a version of the basic cycle being in the locations as they become available on reading for a directly preceding version of the basic cycle, the order of writing the data-items in successive cycles being alternately an order of locations with monotonously ascending or descending addresses and an order with addresses permuted according to a pseudo random function.

5. A transmitting method for transmission of data, the transmitting method comprising transmitting data items that are pseudo random interleaved, the data items being transmitted modulated in a number of simultaneously active frequency channels, wherein the data items are interleaved so as to provide an inverse of de-interleaving that is obtained by writing the received data-items into locations in a memory in an order of writing and reading the data-items in a de-interleaved order of reading, de-interleaving being performed in successive versions of a basic cycle, the data-items for a version of the basic cycle being in the locations as they become available on reading for a directly preceding version of the basic cycle, the order of writing the data-items in successive cycles being alternately an order of locations with monotonously ascending or descending addresses and an order with addresses permuted according to a pseudo random function.

6. A transmitting method according to Claim 5, said transmitting step comprising:

- writing the data items from each logic succession into a further memory in a further order of writing addresses for the particular version of the basic cycle;
- reading the data items for that particular version from the further memory in a further order of reading addresses for the particular version, permuted according to an inverse of the pseudo random function with respect to the further order writing addresses for the particular version, the writing of the data-items of the particular version being performed at addresses as these addresses come available during reading of the data items from the further memory during a directly preceding version of the basic cycle;
- generating the further orders of writing and reading addresses, the further order of reading addresses in the particular version of the basic cycle being permuted with respect to the further order of reading addresses used in a directly preceding version of the basic cycle according to the inverse of the pseudo random function, the inverse of the pseudo random function being particular to the version of the basic cycle,
- wherein the further order of reading and writing addresses is repeated periodically, each further order of reading addresses recurring each time after a period of exactly two versions of the basic cycle, the further order of reading addresses being alternately a monotonously ascending or descending order of addresses and a further order in which the addresses for reading are permuted according to the inverse of the pseudo random function.

7. A system for transmission and reception of data, the system comprising:

- a transmitting section for pseudo-random interleaving data items, the data-items being transmitted modulated in a number of simultaneously active frequency channels and transmitted via a transmission channel;

- a receiving section for receiving and de-interleaving the transmitted data-items, **characterized in that** the receiving section comprises a memory, de-interleaving in the receiving section comprising writing the received data-items into locations in the memory in an order of writing and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function, the transmitting section being arranged to interleave the data-items so as to provide an inverse of the de-interleaving.

8. A system according to Claim 7, the system comprising:

- the transmitter section comprising:

  * an encoder (10) for encoding the data in each version of the basic cycle into a respective logic succession of data-items in an error correction code which is more robust against errors that are separate from each other than against errors that occur in a burst in the respective logic succession;
  * a signal generator (14) for generating a signal comprising a number of frequency channels the data-items for a version of the basic cycle being modulated in respective ones of the frequency channels that are simultaneously active;
  * selecting means (12) for selecting for each particular data-item a particular frequency channel dependent on a particular position of the data-item in its logic succession;
  * a modulator (14) for modulating each frequency channel of the signal in dependence on at least a respective one of the data items, the particular data item being modulated at the particular frequency channel;
  * a transmitter for transmitting the signal via the transmission channel;

- a receiving section comprising:

  * a reception input for receiving the signal from the transmission channel;
  * a demodulator (16) for demodulating the data-items from frequency channels of the signal;
  * inverse selecting means (18, 52, 54, 56) for selecting the logic position of the particular data-item in its respective logic succession, dependent on the particular frequency channel from which the particular data-item was demodulated;
  * a decoder for decoding the data-items received according to the error correcting code applied to the logic sequence as obtained by the inverse selecting means (18, 52, 54, 56);

- **characterized in that** the inverse selecting means (18, 52, 54, 56) comprise:

  * a memory;
  * writing means for, upon reception from the demodulator (16), writing the data items from each particular version of the basic cycle into the memory in an order of writing addresses for the particular version;
  * reading means for reading the data items for that particular version from the memory in an order of reading addresses for the particular version, permuted according to a pseudo random function with respect to the order of writing addresses for the particular version, the writing means writing the data-items of the particular version at addresses as these addresses come available during reading of the data items of a directly preceding version of the basic cycle;
  * address generating means (52, 54) for generating the orders of writing and reading addresses, the order of reading addresses in the particular version of the basic cycle being permuted with respect to the order of reading addresses used in a directly preceding version of the basic cycle according to the pseudo random function, the pseudo random function being particular to the version of the basic cycle;

the address generating means generating the order of reading and writing addresses periodically, each order of reading addresses recurring each time after a period of exactly two versions of the basic cycle, the order of reading addresses being alternately a monotonously ascending or descending order of addresses and an order in which the addresses for reading are permuted according to the pseudo random function;

- the selecting means (12) of the transmitting section selecting the particular frequency channel for positions in each respective logic succession so as to provide an inverse of the assignment of data-items from frequency channels to positions in the respective logic succession performed by the inverse selecting means (18, 52, 54, 56) of the receiving section.

9. Transmission system according to Claim 8, in which the addresses of the memory locations are calculated according to a linear congruential sequence satisfying:

$$X_{n+1} = (a\,X_n + c)\bmod M$$

n being the position of a particular data-item in the order of reading addresses, $X_n$ being the address from which that particular data item is read, M being the number of selectable memory locations a and c being a factor and a summand for a linear congruential sequence respectively, the combination of the factor and the summand being changed for each version of the basic cycle.

10. A receiving device for a system for transmission and reception of data, the receiving device being arranged to receive and de-interleave the transmitted data-items, wherein the receiving section comprises a memory, de-interleaving in the receiving section comprising writing the received data-items into locations in the memory in an order of writing and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function.

11. A transmitting device for a system for transmission and reception of data, the transmitting device being arranged to pseudo-random interleave the data items, the data-items being transmitted modulated in a number of simultaneously active frequency channels and transmitted via a transmission channel, wherein the transmitting section is arranged to interleave the data-items so as to provide an inverse of a de-interleaving that comprises writing the received data-items into locations in a memory in an order of writing and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function.

12. A transmitting device according to Claim 11, the selecting means (12) in the transmitting device comprising:

- writing means for writing the data items from each logic succession into a further memory in a further order of writing addresses for the particular version of the basic cycle;
- reading means for reading the data items for that particular version from the further memory in a further order of reading addresses for the particular version, permuted according to an inverse of the pseudo random function with respect to the further order writing addresses for the particular version, the writing of the data-items of the particular version being performed at addresses as these addresses come available during reading of the data items from the further memory during a directly preceding version of the basic cycle;
- generating means (52, 54) for generating the further orders of writing and reading addresses, the further order of reading addresses in the particular version of the basic cycle being permuted with respect to the further order of reading addresses used in a directly preceding version of the basic cycle according to the inverse of the pseudo random function, the inverse of the pseudo random function being particular to the version of the basic cycle,
- wherein the further order of reading and writing addresses is repeated periodically, each further order of reading addresses recurring each time after a period of exactly two versions of the basic cycle, the further order of reading addresses being alternately a monotonously ascending or descending order of addresses and a further order in which the addresses for reading are permuted according to the inverse of the pseudo random function.

**Patentansprüche**

1.  Verfahren zum fehlergesicherten Übertragen und Empfangen von Daten,
    wobei dieses Verfahren die nachfolgenden Verfahrensschritte umfasst:

    -   einen Sendeschritt, der das Übertragen von Datenitems umfasst, die pseudobeliebig verschachtelt werden, wobei die Datenitems moduliert über eine Anzahl gleichzeitig aktiver Frequenzkanäle übertragen werden;
    -   einen Empfangsschritt, der das Empfangen, das Entschachteln und das Decodieren der übertragenen Datenitems umfasst, **dadurch gekennzeichnet, dass** das Entschachteln das in einer Reihenfolge Einschreiben von empfangenen Datenitems an Stellen in einem Speicher umfasst, sowie das Auslesen der Datenitems in einer entschachtelten Lesereihenfolge, wobei das Entschachteln in aufeinander folgenden Versionen eines Basiszyklus erfolgt, wobei die Datenitems für eine Version des Basiszyklus an den Stellen geschrieben werden, wenn die Stellen beim Auslesen für eine unmittelbar vorhergehende Version des Basiszyklus verfügbar werden, wobei die Reihenfolge des Einschreibens der Datenitems in aufeinander folgenden Zyklen abwechselnd eine Reihenfolge von Stellen mit monoton ansteigenden oder abfallenden Adressen ist und einer Reihenfolge mit Adressen, die entsprechend einer pseudobeliebigen Funktion permutiert worden sind, wobei die Datenitems verschachtelt werden um eine inverse Form der Entschachtelung zu schaffen.

2.  Verfahren nach Anspruch 1, wobei

    -   der Übertragungsschritt die nachfolgenden Verfahrensschritte umfasst:

        *   das Codieren der Daten in jeder Version des Basiszyklus in eine betreffende logische Folge von Datenitems in einem Fehlerkorrekturcode, der robuster ist gegenüber Fehlern, die voneinander getrennt sind als gegenüber Fehlern, die in einem Burst in der betreffenden logischen Folge auftreten;
        *   das Erzeugen eines Signals mit den Frequenzkanälen, wobei die Datenitems für eine Version des Basiszyklus in betreffenden Kanälen der Frequenzkanäle, die gleichzeitig aktiv sind, moduliert werden;
        *   das für jedes betreffende Datenitem Selektieren eines betreffenden Frequenzkanals, und zwar abhängig von einer bestimmten Stelle des Datenitems in der logischen Aufeinanderfolge;
        *   das Modulieren jedes Frequenzkanals des Signals, und zwar abhängig von wenigstens einem bestimmten Datenitem, wobei dieses bestimmte Datenitem in dem bestimmten Frequenzkanal moduliert wird;
        *   das Übertragen des Signals;

    ein Empfangsschritt die nachfolgenden Verfahrensschritte umfasst:

        *   das Empfangen des Signals;
        *   das Demodulieren der Datenitems aus den Frequenzkanälen mit dem Signal;
        *   das inverse Selektieren der logischen Stelle des betreffenden Datenitems in der betreffenden logischen Folge, abhängig von dem betreffenden Frequenzkanal, aus dem das betreffende Datenitem demoduliert wurde;
        *   das Decodieren der empfangenen Datenitems aus den Auslesemitteln entsprechend dem Fehler korrigierenden Code, der der logischen Sequenz zugeführt wird, erhalten durch die genannte inverse Selektion;

    **dadurch gekennzeichnet, dass** die inverse Selektion Folgendes umfasst:

        *   bei Empfang aus der Demodulation, das Einschreiben der Datenitems aus jeder betreffenden Version des Basiszyklus in einen Speicher, und zwar in einer Reihenfolge des Einschreibens von Adressen für die betreffende Version;
        *   das Auslesen der Datenitems für die betreffende Version aus dem Speicher in einer Reihenfolge des Auslesens von Adressen für die betreffende Version, die entsprechend einer pseudobeliebigen Funktion gegenüber der Reihenfolge des Einschreibens von Adressen für die betreffende Version permutiert worden ist, wobei das Einschreiben der Datenitems der betreffenden Version an Adressen geschieht, wenn diese Adressen verfügbar werden beim Auslesen der Datenitems einer unmittelbar vorhergehenden Version des Basiszyklus;
        *   das Erzeugen der Reihenfolgen des Einschreibens und des Auslesens von Adressen, wobei die Reihenfolge des Auslesens von Adressen in der bestimmten Version des Basiszyklus gegenüber der Reihenfolge des Auslesens von Adressen, verwendet in einer unmittelbar vorhergehenden Version des Basiszyklus entsprechend der pseudobeliebigen Funktion permutiert ist, wobei die pseudobeliebige Funktion speziell für die Version des Basiszyklus ist; wobei die Reihenfolge des Auslesens und des Einschreibens von Adressen periodisch wiederholt wird, wobei jede Reihenfolge des Auslesens von Adressen jeweils nach einer Periode von genau zwei Versionen des Basiszyklus zurückkehrt, wobei die Reihenfolge des Auslesens von Adressen abwechselnd eine ansteigende oder abfallende Reihenfolge von Adressen ist und eine Reihenfolge, in der die Adressen zum Auslesen entsprechend der pseudobeliebigen Funktion permutiert sind;

- wobei das genannte Selektieren in dem Sendeschritt das Selektieren des bestimmten Frequenzkanals für Positionen in jeder betreffenden logischen Folge zum Schaffen einer Inverse der Zuordnung von Datenitems aus Frequenzkanälen zu Positionen in der betreffenden logischen Aufeinanderfolge, durchgeführt durch die inverse Selektion des Empfangsschrittes umfasst.

3. Verfahren zum Übertragen nach Anspruch 2, wobei die Adressen der Speicherstellen entsprechend einer linearen kongruenten Sequenz berechnet werden, die der nachfolgenden Gleichung entspricht:

$$X_{n+1} = (aX_n + c) \bmod M$$

wobei n die Stelle eines bestimmten Datenitems in der Reihenfolge des Auslesens von Adressen ist, wobei $X_n$ die Adresse ist, von der dieses bestimmte Datenitem ausgelesen wird,
wobei M die Anzahl selektierbarer Speicherstelle ist, wobei a und c ein Faktor bzw. ein Summand für eine lineare kongruente Sequenz ist, wobei die Kombination des Faktors und des Summanden für jede Version des Basiszyklus geändert wird.

4. Empfangsverfahren zum Empfangen von fehlergesicherten Daten, wobei Datenitems übertragen werden, die in einer Anzahl gleichzeitig aktiver Frequenzkanäle moduliert sind, wobei das Empfangsverfahren die nachfolgenden Verfahrensschritte umfasst: das Empfangen, das Entschachteln der übertragenen Daten, wobei das Entschachteln die nachfolgenden Verfahrensschritte umfasst: das Schreiben der empfangenen Datenitems an Stellen in einem Speicher in einer Reihenfolge des Schreibens und Auslesens der Datenitems in einer entschachtelten Reihenfolge, wobei das Entschachteln in aufeinander folgenden Versionen eines Basiszyklus durchgeführt wird, wobei sich die Datenitems für eine Version des Basiszyklus an denjenigen Stellen befinden, die beim Auslesen verfügbar werden für eine unmittelbar vorhergehende Version des Basiszyklus, wobei die Reihenfolge des Einschreibens der Datenitems in aufeinander folgenden Zyklen abwechselnd eine Reihenfolge von Stellen mit monoton ansteigenden oder abfallenden Adressen ist und eine Reihenfolge mit Adressen, die entsprechend einer pseudobeliebigen Funktion permutiert sind.

5. Übertragungsverfahren zur fehlergesicherten Übertragung von Daten, wobei das Übertragungsverfahren die nachfolgenden Verfahrensschritte umfasst: das Senden von Datenitems, die pseudobeliebig verschachtelt werden, wobei die Datenitems in einer Anzahl gleichzeitig aktiver Frequenzkanäle moduliert übertragen werden, wobei die Datenitems verschachtelt werden zum Schaffen einer Inverse der Entschachtelung, die **dadurch** erhalten worden ist, dass die empfangenen Datenitems an Stellen in einem Speicher geschrieben werden, und zwar in einer Reihenfolge des Schreibens und Auslesens der Datenitems in einer entschachtelten Reihenfolge des Auslesens, wobei das Entschachteln in aufeinander folgenden Versionen eines Basiszyklus durchgeführt wird, wobei die Datenitems für eine Version des Basiszyklus sich an den Stellen befinden, wie diese beim Lesen verfügbar werden für eine unmittelbar vorhergehende Version des Basiszyklus, wobei die Reihenfolge des Schreibens der Datenitems in aufeinander folgenden Zyklen abwechselnd eine Reihenfolge von Stellen mit monoton ansteigenden oder abfallenden Adressen ist und eine Reihenfolge mit Adressen, die entsprechend einer pseudobeliebigen Funktion permutiert worden sind.

6. Übertragungsverfahren nach Anspruch 5, wobei der genannte Übertragungsschritt Folgendes umfasst:

- das Schreiben der Datenitems aus jeder logischen Aufeinanderfolge in einen weiteren Speicher in einer weiteren Reihenfolge des Schreibens von Adressen für die bestimmte Version des Basiszyklus;
- das Lesen der Datenitems für diese bestimmte Version aus dem weiteren Speicher in einer weiteren Reihenfolge des Auslesens von Adressen für die bestimmte Version, permutiert entsprechend einer Inversen der pseudobeliebigen Funktion gegenüber der weiteren Reihenfolge des Schreibens von Adressen für die bestimmte Version, wobei das Schreiben der Datenitems der bestimmten Version an Adressen geschieht, wenn diese Adressen beim Auslesen der Datenitems aus dem weiteren Speicher während einer unmittelbar vorhergehenden Version des Basiszyklus verfügbar werden;

- das Erzeugen der weiteren Reihenfolgen des Schreibens und des Lesens von Adressen,

wobei diese weitere Reihenfolge des Auslesens von Adressen in der bestimmten Version des Basiszyklus gegenüber der weiteren Reihenfolge des Auslesens von Adressen, die in einer unmittelbar vorhergehenden Version des Basiszyklus verwendet worden ist, entsprechend der Inversen der pseudobeliebigen Funktion, wobei die Inverse der pseudobeliebigen Funktion speziell für die Version des Basiszyklus ist:

- wobei die weitere Reihenfolge des Lesens und des Schreibens von Adresen periodisch wiederholt wird, wobei jede weitere Reihenfolge des Auslesens von Adressen jeweils nach einer Periode von genau zwei Versionen des Basiszyklus zurückkehrt, wobei die weitere Reihenfolge des Auslesens von Adressen abwechselnd eine monoton ansteigende oder abfallende Reihenfolge von Adressen ist und eine weitere Reihenfolge ist, in der die Adressen zum Auslesen entsprechend der Inversen der pseudobeliebigen Funktion permutiert werden.

7. System zur fehlergesicherten Übertragung und Empfang von Daten, wobei dieses System die nachfolgenden Elemente umfasst:

- einen Sendeteil zum pseudobeliebigen Verschachteln der Datenitems, wobei die Datenitems moduliert in einer Anzahl gleichzeitig aktiver Frequenzkanäle und über einen Übertragungskanal übertragen werden;
- einen Empfangsteil zum Empfangen und Entschachteln der übertragenen Datenitems,

**dadurch gekennzeichnet, dass** der Empfangsteil einen Speicher umfasst, dass das Entschachteln in dem Empfangsteil das Schreiben der empfangenen Datenitems an Stellen in dem Speicher umfasst, und zwar in einer Reihenfolge des Schreibens und Lesens der Datenitems in einer entschachtelten Reihenfolge des Lesens, wobei Entschachtelung in aufeinander folgenden Versionen eines Basiszyklus durchgeführt wird, wobei die Datenitems für eine Version des Basiszyklus an den Stellen geschrieben werden, die beim Auslesen für eine unmittelbar vorhergehende Version des Basiszyklus frei werden, wobei die Reihenfolge des Schreibens der Datenitems in aufeinander folgenden Zyklen abwechselnd eine Reihenfolge von Stellen mit monoton ansteigenden oder abfallenden Adressen und eine Reihenfolge mit Adressen ist, die entsprechend einer pseudobeliebigen Funktion permutiert worden ist, wobei der Sendeteil zum Verschachteln der Datenitems vorgesehen ist zum Schaffen einer Inversen der Entschachtelung.

8. System nach Anspruch 7, wobei dieses System die nachfolgenden Elemente umfasst:

- den Sendeteil, der Folgendes umfasst:

  * einen Codierer (10) zum Codieren der Daten in jeder Version des Basiszyklus in eine betreffende logische Aufeinanderfolge von Datenitems in dem Fehlerkorrekturcode, der robuster ist gegenüber Fehlern, die voneinander getrennt sind, als gegenüber Fehlern, die in einem Burst in der betreffenden logischen Aufeinanderfolge auftreten;
  * einen Signalgenerator (14) zum Erzeugen eines Signals mit einer Anzahl Frequenzkanäle,

wobei die Datenitems für eine Version des Basiszyklus in betreffenden Kanälen der Frequenzkanäle moduliert werden, die gleichzeitig aktiv sind;

  * Selektionsmittel (12) zum für jedes bestimmte Datenitem Selektieren eines betreffenden Frequenzkanals, abhängig von einer bestimmten Stelle des Datenitems in der logischen Aufeinanderfolge;
  * einen Modulator (14) zum Modulieren jedes Frequenzkanals des Signals in Abhängigkeit von wenigstens einem betreffenden Item der Datenitems, wobei das betreffende Datenitem mit dem betreffenden Frequenzkanal moduliert ist;
  * einen Sender zum Übertragen des Signals über den Übertragungskanal;

    - wobei ein Empfangsteil Folgendes umfasst:

  * einen Empfangseingang zum Empfangen des Signals aus dem Übertragungskanal;
  * einen Demodulator (16) zum Demodulieren der Datenitems aus Frequenzkanälen des Kanals;
  * inverse Selektionsmittel (18, 52, 54, 56) zum Selektieren der logischen Stelle des betreffenden Datenitems in der betreffenden logischen Aufeinanderfolge, abhängig von dem betreffenden Frequenzkanal, aus dem das betreffende Datenitem demoduliert wurde;

* einen Decoder zum Decodieren der Datenitems, die entsprechend dem Fehler korrigierenden Code empfangen wurden, der der logischen Sequenz zugeführt wurde. Die durch die inversen Selektionsmittel (18, 52, 54, 56) erhalten worden sind;

**dadurch gekennzeichnet, dass** die inversen Selektionsmittel (18, 52, 54, 56) die nachfolgenden Elemente aufweisen:

* einen Speicher;
* Schreibmittel um, bei Empfang von dem Demodulator (16), die Datenitems von jeder bestimmten Version des Basiszyklus in den Speicher einzuschreiben, und zwar in einer Reihenfolge des Einschreibens von Adressen für die bestimmte Version;
* Auslesemittel zum Auslesen der Datenitems für diese bestimmte Version aus dem Speicher in einer Reihenfolge des Auslesens von Adressen für die bestimmte Version, permutiert entsprechend einer pseudobeliebigen Funktion gegenüber der Reihenfolge des Schreibens von Adressen für die bestimmte Version, wobei die Schreibmittel die Datenitems der betreffenden Version an Adressen schreiben, wenn diese Adressen beim Auslesen der Datenitems einer unmittelbar vorhergehenden Version des Basiszyklus verfügbar werden;
* Adressenerzeugungsmittel (52, 54) zum Erzeugen der Reihenfolgen des Schreibens und des Lesens von Adressen, wobei die Reihenfolge des Lesens von Adressen in der bestimmten Version des Basiszyklus permutiert ist gegenüber der Reihenfolge des Auslesens von Adressen, die in einer unmittelbar vorhergehenden Version des Basiszyklus verwendet worden sind, und zwar entsprechend der pseudobeliebigen Funktion, wobei die pseudobeliebige Funktion speziell ist für die Version des Basiszyklus; wobei die Adressenerzeugungsmittel die Reihenfolge des Auslesens und des Schreibens von Adressen periodisch erzeugen, wobei jede Reihenfolge des Auslesens von Adressen jeweils nach einer Periode von genau zwei Versionen des Basiszyklus zurückkehrt, wobei die Reihenfolge des Auslesens von Adressen abwechselnd eine monoton ansteigende oder abfallende Reihenfolge von Adressen und eine Reihenfolge ist, in der die Adressen zum Auslesen entsprechend der pseudobeliebigen Funktion permutiert werden;
* wobei die Selektionsmittel (12) des Sendeteils den betreffenden Frequenzkanal selektiert für Positionen in jeder betreffenden logischen Aufeinanderfolge zum Schaffen einer Inversen der Zuordnung von Datenitems aus Frequenzkanälen zu Positionen in der betreffenden logischen Aufeinanderfolge, durchgeführt durch die inversen Selektionsmittel (18, 52, 54, 56) des Empfangsteils.

9. Übertragungssystem nach Anspruch 8, wobei die Adressen der Speicherstellen entsprechend einer linearen kongruenten Sequenz berechnet werden, wobei diese Sequenz der nachfolgenden Gleichung entspricht:

$$X_{n+1}=(aX_n+c) \bmod M$$

wobei n die Position eines bestimmten Datenitems in der Reihenfolge des Auslesens von Adressen ist, wobei $X_n$ die Adresse ist, aus der dieses bestimmte Datenitem ausgelesen wird, wobei M die Anzahl selektierbarer Speicherstellen ist, a und c ist, wobei a und c ein Faktor bzw. ein Summand für eine lineare deckungsgleiche Sequenz sind, wobei die verwendete Kombination des Faktors und des Summanden für jede Version des Ausgangszyklus geändert wird.

10. Empfangsanordnung für ein System zur fehlersicheren Übertragung und zum fehlersicheren Empfang von Daten, wobei die Empfangsanordnung dazu vorgesehen ist, die übertragenen Datenitems zu empfangen und zu entschachteln, wobei die Empfangsanordnung einen Speicher aufweist, wobei das Entschachteln in der Empfangsanordnung das Einschreiben der empfangenen Datenitems an die Stellen in dem Speicher in einer Reihenfolge von Schreiben und Lesen der Datenitems in einer entschachtelten Reihenfolge von Schreiben umfasst, wobei das Entschachteln in aufeinander folgenden Versionen eines Basiszyklus erfolgt, wobei die Datenitems für eine Version des Basiszyklus an die Stellen geschrieben werden, wenn die Stellen beim Auslesen für eine unmittelbar vorhergehende Version des Basiszyklus verfügbar werden, wobei die Reihenfolge des Schreibens von Datenitems in aufeinander folgenden Zyklen abwechselnd eine Reihenfolge von Stellen mit monoton ansteigenden oder abfallenden Adressen ist und eine Reihenfolge mit Adressen, die entsprechend einer pseudobeliebigen Funktion permutiert sind.

11. Übertragungsanordnung für ein System zur fehlergesicherten Übertragung und für fehlergesicherten Empfang von Daten, wobei die Übertragungsanordnung dazu vorgesehen ist, die Datenitems pseudobeliebig zu Verschachteln, wobei die Datenitems moduliert in einer Anzahl gleichzeitig aktiver Frequenzkanäle moduliert und über einen Übertragungskanal übertragen werden, wobei die Übertragungsanordnung dazu vorgesehen ist, die Datenitems zu verschachteln um eine Inverse einer Entschachtelung zu schaffen, die das Schreiben der empfangenen Datenitems an Stellen in einem Speicher in einer Reihenfolge von Schreiben und Lesen der Datenitems in einer entschachtelten Reihenfolge von Lesen umfasst, wobei das Entschachteln in aufeinander folgenden Versionen eines Basiszyklus durchgeführt wird, wobei die Datenitems für eine Version des Basiszyklus an die Stellen geschrieben werden, wenn die Stellen beim Lesen für eine unmittelbar vorhergehende Version des Basiszyklus verfügbar werden, wobei die Reihenfolge des Schreibens der Datenitems in aufeinander folgenden Zyklen abwechselnd eine Reihenfolge von Stellen mit monoton ansteigenden oder abfallenden Adressen und eine Reihenfolge mit Adressen ist, die entsprechend einer pseudobeliebigen Funktion permutiert sind.

12. Übertragungsanordnung nach Anspruch 11, wobei die Selektionsmittel (12) in der Übertragungsanordnung die nachfolgenden Elemente aufweisen:

- Schreibmittel zum Schreiben der Datenitems aus jeder logischen Aufeinanderfolge in einen weiteren Speicher in einer weiteren Reihenfolge des Schreibens von Adressen für die betreffende Version des Basiszyklus;
- Lesemittel zum Auslesen der Datenitems für die betreffende Version aus dem weiteren Speicher in einer weiteren Reihenfolge des Auslesens von Adressen für die betreffende Version, permutiert entsprechend einer Inverse der pseudobeliebigen Funktion gegenüber der weiteren Reihenfolge des Schreibens von Adressen für die betreffende Version, wobei das Schreiben der Datenitems der betreffenden Version an Adressen erfolgt, wenn diese Adressen beim Auslesen der Datenitems aus dem weiteren Speicher während einer unmittelbar vorhergehenden Version des Basiszyklus verfügbar werden;
- Erzeugungsmittel (52, 54) zum Erzeugen der weiteren Reihenfolgen von Schreiben und Lesen von Adressen, wobei die weitere Reihenfolge des Lesens von Adressen in der betreffenden Version des Basiszyklus gegenüber der weiteren Reihenfolge des Lesens von Adressen permutiert ist, die in einer unmittelbar vorhergehenden Version des Basiszyklus entsprechend der Inverse der pseudobeliebigen Funktion verwendet worden ist, wobei die Inverse der pseudobeliebigen Funktion speziell für die Version des Basiszyklus ist, in der die weitere Reihenfolge des Auslesens und Einschreibens von Adressen periodisch wiederholt wird,
- wobei die weitere Reihenfolge des Auslesens von Adressen jeweils nach einer Periode von genau zwei Versionen des Basiszyklus wiederholt wird, wobei die weitere Reihenfolge des Auslesens von Adressen abwechselnd eine monoton ansteigende oder abfallende Reihenfolge ist und eine weitere Reihenfolge, in der die Adressen zum Auslesen entsprechend der Inverse der pseudobeliebigen Funktion permutiert sind.

## Revendications

1. Procédé de transmission et de réception de données, le procédé comprenant :

- une étape de transmission comprenant la transmission d'éléments de données qui sont entrelacés de manière pseudo aléatoire, les éléments de données étant transmis, modulés dans un certain nombre de canaux de fréquences simultanément actifs ;
- une étape de réception comprenant la réception et le désentrelacement des éléments de données transmis, **caractérisé en ce que** le désentrelacement comprend l'écriture des éléments de données reçus dans des emplacements d'une mémoire dans un ordre d'écriture, et la lecture des éléments de données dans un ordre de lecture désentrelacé, le désentrelacement étant effectué dans des versions successives d'un cycle fondamental, les éléments de données pour une version du cycle fondamental étant écrits dans les emplacements à mesure que ceux-ci deviennent disponibles lors de la lecture pour une version directement précédente du cycle fondamental, l'ordre d'écriture des éléments de données dans des cycles successifs étant tour à tour un ordre d'emplacements avec des adresses croissant ou décroissant de manière monotone et un ordre avec des adresses permutées suivant une fonction pseudo aléatoire, les éléments de données étant entrelacés de manière à fournir l'inverse du désentrelacement.

2. Procédé selon la revendication 1, dans lequel :

- l'étape de transmission comprend :

  - le codage des données dans chaque version du cycle fondamental en une succession logique respective d'éléments de données dans un code de correction d'erreurs qui résiste davantage aux erreurs qui sont séparées l'une de l'autre qu'aux erreurs qui se présentent en salve dans la succession logique respective ;

- la génération d'un signal comprenant les canaux de fréquences, les éléments de données pour une version du cycle fondamental étant modulés dans des canaux de fréquences respectifs qui sont simultanément actifs ;

- la sélection pour chaque élément de données particulier d'un canal de fréquences particulier qui dépend d'une position particulière de l'élément de données dans sa succession logique ;

- la modulation de chaque canal de fréquences du signal en fonction d'au moins un des éléments de données respectifs, l'élément de données particulier étant modulé au niveau du canal de fréquences particulier ;

- la transmission du signal ;

- l'étape de réception comprenant :

- la réception du signal ;

- la démodulation des éléments de données à partir des canaux de fréquences du signal ;

- la sélection inverse de la position logique de l'élément de données particulier dans sa succession logique respective, en fonction du canal de fréquences particulier à partir duquel l'élément de données particulier a été démodulé ;

- le décodage des éléments de données reçus des moyens de lecture suivant le code de correction d'erreurs appliqué à la séquence logique obtenue par ladite sélection inverse ;

- **caractérisé en ce que** la sélection inverse comprend :

- lors de la réception depuis la démodulation, l'écriture des éléments de données provenant de chaque version particulière du cycle fondamental dans une mémoire dans un ordre d'adresses d'écriture pour la version particulière ;

- la lecture des éléments de données pour cette version particulière depuis la mémoire dans un ordre d'adresses de lecture pour la version particulière, permuté suivant une fonction pseudo aléatoire par rapport à l'ordre d'adresses d'écriture pour la version particulière, l'écriture des éléments de données de la version particulière étant effectuée au niveau d'adresses à mesure que ces adresses deviennent disponibles pendant la lecture des éléments de données d'une version directement précédente du cycle fondamental ;

- la génération des ordres d'adresses d'écriture et de lecture, l'ordre d'adresses de lecture dans la version particulière du cycle fondamental étant permuté par rapport à l'ordre d'adresses de lecture utilisé dans une version directement précédente du cycle fondamental suivant la fonction pseudo aléatoire, la fonction pseudo aléatoire étant particulière à la version du cycle fondamental; l'ordre d'adresses de lecture et d'écriture étant répété périodiquement, chaque ordre d'adresses de lecture réapparaissant chaque fois après une période d'exactement deux versions du cycle fondamental, l'ordre des adresses de lecture étant tour à tour un ordre d'adresses croissant ou décroissant de manière monotone et un ordre dans lequel les adresses de lecture sont permutées suivant la fonction pseudo aléatoire ;

- dans lequel ladite sélection dans l'étape de transmission comprend la sélection du canal de fréquences particulier pour des positions dans chaque succession logique respective de manière à fournir une inverse de l'attribution des éléments de données provenant de canaux de fréquences à des positions dans la succession logique respective effectuée par la sélection inverse de l'étape de réception.

**3.** Procédé de transmission selon la revendication 2, dans lequel les adresses des emplacements de mémoire sont calculées suivant une séquence congruente linéaire satisfaisant à :

$$X_{n+1} = (a\,X_n + c)\bmod M$$

n étant la position d'un élément de données particulier dans l'ordre d'adresses de lecture, $X_n$ étant l'adresse depuis laquelle cet élément de données particulier est lu, M étant le nombre d'emplacements de mémoire sélectionnables, a et c étant respectivement un facteur et un opérande de somme pour une séquence congruente linéaire, la combinaison du facteur et de l'opérande de somme étant modifiée pour chaque version du cycle fondamental.

**4.** Procédé de réception pour la réception de données, des éléments de données étant transmis, modulés dans un certain nombre de canaux de fréquences simultanément actifs, le procédé de réception comprenant la réception et le désentrelacement des données transmises, dans lequel le désentrelacement comprend l'écriture des éléments de données reçus dans des emplacements d'une mémoire dans un ordre d'écriture et de lecture des éléments de données dans un ordre de lecture désentrelacé, le désentrelacement étant effectué dans des versions successives d'un cycle fondamental, les éléments de données pour une version du cycle fondamental se trouvant dans les emplacements à mesure qu'ils deviennent disponibles à la lecture pour une version directement précédente du cycle fondamental, l'ordre d'écriture des éléments de données dans des cycles successifs étant tour à tour un ordre d'emplacements avec des adresses croissant ou décroissant de manière monotone et un ordre avec des adresses permutées suivant une fonction pseudo aléatoire.

5. Procédé de transmission pour la transmission de données, le procédé de transmission comprenant la transmission d'éléments de données qui sont entrelacés d'une manière pseudo aléatoire, les éléments de données étant transmis modulés dans un certain nombre de canaux de fréquences simultanément actifs, dans lequel les éléments de données sont entrelacés de manière à fournir un inverse du désentrelacement qui est obtenu en écrivant les éléments de données reçus dans des emplacements dans une mémoire dans un ordre d'écriture et de lecture des éléments de données dans un ordre désentrelacé de lecture, le désentrelacement étant effectué dans des versions successives d'un cycle fondamental, les éléments de données pour une version du cycle fondamental se trouvant dans les emplacements à mesure qu'ils deviennent disponibles à la lecture pour une version directement précédente du cycle fondamental, l'ordre d'écriture des éléments de données dans des cycles successifs étant tour à tour un ordre d'emplacements avec des adresses croissant ou décroissant de manière monotone et un ordre avec des adresses permutées suivant une fonction pseudo aléatoire.

6. Procédé de transmission selon la revendication 5, ladite étape de transmission comprenant :

- l'écriture des éléments de données de chaque succession logique dans une autre mémoire dans un autre ordre d'adresses d'écriture pour la version particulière du cycle fondamental ;
- la lecture des éléments de données pour cette version particulière depuis l'autre mémoire dans un autre ordre d'adresses de lecture pour la version particulière, permuté suivant une inverse de la fonction pseudo aléatoire par rapport à l'autre ordre d'adresses d'écriture pour la version particulière, l'écriture des éléments de données de la version particulière étant effectuée à des adresses à mesure que ces adresses deviennent disponibles pendant la lecture des éléments de données depuis l'autre mémoire pendant une version directement précédente du cycle fondamental ;

- la génération des autres ordres d'adresses d'écriture et de lecture, l'autre ordre d'adresses de lecture dans la version particulière du cycle fondamental étant permuté par rapport à l'autre ordre d'adresses de lecture utilisé dans une version directement précédente du cycle fondamental suivant l'inverse de la fonction pseudo aléatoire, l'inverse de la fonction pseudo aléatoire étant particulière à la version du cycle fondamental ;
- dans lequel l'autre ordre d'adresses de lecture et d'écriture est répété périodiquement, chaque autre ordre d'adresses de lecture se représentant chaque fois après une période d'exactement deux versions du cycle fondamental, l'autre ordre d'adresses de lecture étant tour à tour un ordre d'adresses croissant ou décroissant de manière monotone et un autre ordre dans lequel les adresses de lecture sont permutées suivant l'inverse de la fonction pseudo aléatoire.

7. Système de transmission et de réception de données, le système comprenant :

- une section de transmission pour entrelacer les éléments de données de manière pseudo aléatoire, les éléments de données étant transmis modulés dans un certain nombre de canaux de fréquences simultanément actifs et par le biais d'un canal de transmission ;
- une section de réception pour recevoir et désentrelacer les éléments de données transmis, **caractérisé en ce que** la section de réception comprend une mémoire, le désentrelacement dans la section de réception comprenant l'écriture des éléments de données reçus dans des emplacements de la mémoire dans un ordre d'écriture et de lecture des éléments de données dans un ordre désentrelacé de lecture, le désentrelacement étant effectué dans des versions successives d'un cycle fondamental, les éléments de données pour une version du cycle fondamental étant écrits dans les emplacements à mesure que ceux-ci deviennent disponibles à la lecture pour une version directement précédente du cycle fondamental, l'ordre d'écriture des éléments de données dans des cycles successifs étant tour à tour un ordre d'emplacements avec des adresses croissant et décroissant de manière monotone et un ordre avec des adresses permutées suivant une fonction pseudo aléatoire, la section de transmission étant agencée pour entrelacer les éléments de données de manière à fournir un inverse du désentrelacement.

8. Système selon la revendication 7, le système comprenant :

- une section d'émetteur comprenant :

  - un codeur (10) pour coder les données dans chaque version du cycle fondamental en une succession logique respective d'éléments de données dans un code de correction d'erreurs qui résiste davantage aux erreurs qui sont séparées l'une de l'autre qu'aux erreurs qui se produisent en salve dans la succession logique respective ;
  - un générateur de signaux (14) pour générer un signal comprenant un certain nombre de canaux de fréquences, les éléments de données pour une version du cycle fondamental étant modulés dans des canaux de fréquences respectifs qui sont simultanément actifs ;
  - un moyen de sélection (12) pour sélectionner, pour chaque élément de données particulier, un canal de fréquence particulier qui dépend d'une position particulière de l'élément de données dans sa succession logique ;
  - un modulateur (14) pour moduler chaque canal de fréquences du signal en fonction d'au moins un des éléments de données, l'élément de données particulier étant modulé au niveau du canal de fréquences particulier ;
  - un émetteur pour transmettre le signal par le biais du canal de transmission;

- une section de réception comprenant :

  - une entrée de réception pour recevoir le signal provenant du canal de transmission ;
  - un démodulateur (16) pour démoduler les éléments de données provenant des canaux de fréquences du signal ;
  - un moyen de sélection inverse (18, 52, 54, 56) pour sélectionner la position logique de l'élément de données particulier dans sa succession logique respective, en fonction du canal de fréquences particulier duquel l'élément de données particulier a été démodulé ;
  - un décodeur pour décoder les éléments de données reçus suivant le code de correction d'erreurs appliqué à la séquence logique telle qu'obtenue par le moyen de sélection inverse (18, 52, 54, 56) ;

- **caractérisé en ce que** le moyen de sélection inverse (18, 52, 54, 56) comprend :

  - une mémoire ;
  - un moyen d'écriture pour, lors de la réception en provenance du démodulateur (16), écrire les éléments de données depuis chaque version particulière du cycle fondamental dans la mémoire dans un ordre d'adresses d'écriture pour la version particulière ;
  - un moyen de lecture pour lire les éléments de données pour cette version particulière depuis la mémoire dans un ordre d'adresses de lecture pour la version particulière, permuté suivant une fonction pseudo aléatoire par rapport à l'ordre d'adresses d'écriture pour la version particulière, le moyen d'écriture écrivant les éléments de données de la version particulière à des adresses à mesure que ces adresses deviennent disponibles pendant la lecture des éléments de données d'une version directement précédente du cycle fondamental ;
  - un moyen de génération d'adresses (52, 54) pour générer les ordres d'adresses d'écriture et de lecture, l'ordre d'adresses de lecture dans la version particulière du cycle fondamental étant permuté par rapport à l'ordre d'adresses de lecture utilisé dans une version directement précédente du cycle fondamental suivant la fonction pseudo aléatoire, la fonction pseudo aléatoire étant particulière à la version du cycle fondamental; le moyen de génération d'adresses générant l'ordre d'adresses de lecture et d'écriture périodiquement, chaque ordre d'adresses de lecture se représentant chaque fois après une période d'exactement deux versions du cycle fondamental, l'ordre d'adresses de lecture étant tour à tour un ordre croissant ou décroissant de manière monotone d'adresses et un ordre dans lequel les adresses de lecture sont permutées suivant la fonction pseudo aléatoire ;

- le moyen de sélection (12) de la section de transmission sélectionnant le canal de fréquences particulier pour des positions dans chaque succession logique respective de manière à fournir une inverse de l'attribution des éléments de données provenant des canaux de fréquences à des positions dans la succession logique respective effectuée par le moyen de sélection inverse (18, 52, 54, 56) de la section de réception.

**9.** Système de transmission selon la revendication 8, dans lequel les adresses des emplacements de mémoire sont calculées suivant une séquence congruente linéaire satisfaisant à :

$$X_{n+1} = (a\, X_n + c)\, \bmod\, M$$

n étant la position d'un élément de données particulier dans l'ordre d'adresses de lecture, $X_n$ étant l'adresse depuis laquelle cet élément de données particulier est lu, M étant le nombre d'emplacements de mémoire sélectionnables, a et c étant respectivement un facteur et un opérande de somme pour une séquence congruente linéaire, la combinaison du facteur et de l'opérande de somme étant modifiée pour chaque version du cycle fondamental.

**10.** Dispositif de réception pour un système de transmission et de réception de données, le dispositif de réception étant agencé pour recevoir et désentrelacer les éléments de données transmis, dans lequel la section de réception comprend une mémoire, le désentrelacement dans la section de réception comprenant l'écriture des éléments de données reçus dans des emplacements de la mémoire dans un ordre d'écriture et de lecture des éléments de données dans un ordre désentrelacé de lecture, le désentrelacement étant réalisé dans des versions successives d'un cycle fondamental, les éléments de données pour une version du cycle fondamental étant écrits dans les emplacements à mesure que les emplacements deviennent disponibles à la lecture pour une version directement précédente du cycle fondamental, l'ordre d'écriture des éléments de données dans des cycles successifs étant tour à tour un ordre d'emplacements avec des adresses croissant et décroissant de manière monotone et un ordre avec des adresses permutées suivant une fonction pseudo aléatoire.

**11.** Dispositif de transmission pour un système de transmission et de réception de données, le dispositif de transmission étant agencé pour entrelacer les éléments de données de manière pseudo aléatoire, les éléments de données étant transmis modulés dans un certain nombre de canaux de fréquences simultanément actifs et transmis par le biais d'un canal de transmission, dans lequel la section de transmission est agencée pour entrelacer les éléments de données de manière à fournir un inverse d'un désentrelacement qui comprend l'écriture des éléments de données reçus dans des emplacements d'une mémoire dans un ordre d'écriture et de lecture des éléments de données dans un ordre désentrelacé de lecture, le désentrelacement étant réalisé dans des versions successives d'un cycle fondamental, les éléments de données pour une version du cycle fondamental étant écrits dans les emplacements à mesure que les emplacements deviennent disponibles à la lecture pour une version directement précédente du cycle fondamental, l'ordre d'écriture des éléments de données dans des cycles successifs étant tour à tour un ordre d'emplacements avec des adresses croissant ou décroissant de manière monotone et un ordre avec des adresses permutées suivant une fonction pseudo aléatoire.

**12.** Dispositif de transmission selon la revendication 11, le moyen de sélection (12) dans le dispositif de transmission comprenant :

- un moyen d'écriture pour écrire les éléments de données de chaque succession logique dans une autre mémoire dans un autre ordre d'adresses d'écriture pour la version particulière du cycle fondamental ;
- un moyen de lecture pour lire les éléments de données pour cette version particulière depuis l'autre mémoire dans un autre ordre d'adresses de lecture pour la version particulière, permuté suivant une inverse de la fonction pseudo aléatoire par rapport à l'autre ordre d'adresses d'écriture pour la version particulière, l'écriture des éléments de données de la version particulière étant réalisée à des adresses à mesure que ces adresses deviennent disponibles pendant la lecture des éléments de données depuis l'autre mémoire pendant une version directement précédente du cycle fondamental ;
- un moyen de génération (52, 54) pour générer les autres ordres d'adresses d'écriture et de lecture, l'autre ordre d'adresses de lecture dans la version particulière du cycle fondamental étant permuté par rapport à l'autre ordre d'adresses de lecture utilisé dans une version directement précédente du cycle fondamental suivant l'inverse de la fonction pseudo aléatoire, l'inverse de la fonction pseudo aléatoire étant particulière à la version du cycle fondamental ;
- dans lequel l'autre ordre d'adresses de lecture et d'écriture est répété périodiquement, chaque autre ordre d'adresses de lecture se représentant chaque fois après une période d'exactement deux versions du cycle fondamental, l'autre ordre d'adresses de lecture étant tour à tour un ordre d'adresses croissant ou décroissant de manière monotone et un autre ordre dans lequel les adresses de lecture sont permutées suivant l'inverse de la fonction pseudo aléatoire.

FIG. 1

FIG. 2

FIG. 3

FIG. 4

FIG. 5